**Europäisches Patentamt**

(19) **European Patent Office**

**Office européen des brevets**

(11) Veröffentlichungsnummer: **0 108 405**
**B1**

(12) # EUROPÄISCHE PATENTSCHRIFT

(45) Veröffentlichungstag der Patentschrift:
**20.04.88**

(51) Int. Cl.⁴: **G 01 R 1/073,** G 01 R 31/28

(21) Anmeldenummer: **83111038.2**

(22) Anmeldetag: **04.11.83**

(54) Vorrichtung zum Prüfen von elektrischen Leiterplatten.

(30) Priorität: **05.11.82 DE 3240916**

(43) Veröffentlichungstag der Anmeldung:
**16.05.84 Patentblatt 84/20**

(45) Bekanntmachung des Hinweises auf die Patenterteilung:
**20.04.88 Patentblatt 88/16**

(84) Benannte Vertragsstaaten:
**AT BE CH DE FR GB IT LI LU NL SE**

(56) Entgegenhaltungen:
**EP - A - 0 050 913**
**JP - A - 57 019 681**
**US - A - 3 848 188**
**US - A - 4 164 704**

(73) Patentinhaber: **Maelzer, Martin, Hagenburger Strasse 26, D-3050 Wunstorf (DE)**
Patentinhaber: **Luther, Erich, Hagenburger Strasse 26, D-3050 Wunstorf (DE)**

(72) Erfinder: **Maelzer, Martin, Hagenburger Strasse 26, D-3050 Wunstorf (DE)**
Erfinder: **Luther, Erich, Hagenburger Strasse 26, D-3050 Wunstorf (DE)**
Erfinder: **Dehmel, Rüdiger, Bruchkamp 5, D-3014 Laatzen 5 (DE)**
Erfinder: **Higgen, Hans Hermann, Am Bückeberg 7, D-3060 Stadthagen (DE)**

(74) Vertreter: **Schmidt-Evers, Jürgen, Dipl.-Ing. et al, Patentanwälte Dipl.-Ing. H. Mitscherlich Dipl.-Ing. K. Gunschmann Dipl.-Ing. Dr.rer.nat. W. Körber Dipl.-Ing. J. Schmidt-Evers Dipl.-Ing. W. Melzer Steinsdorfstrasse 10, D-8000 München 22 (DE)**

ACTORUM AG

## Beschreibung

Die Erfindung betrifft eine Vorrichtung zum Prüfen von elektronischen Leiterplatten, mit einem Auflageteil für die jeweils zu prüfende Leiterplatte, mit einer Vielzahl von im Lochraster der zu prüfenden Leiterplatte angeordneten und mit dieser direkt oder unter Zwischenschaltung eines Rasteranpassungsadapters federnd kontaktierbaren Prüfstiften, mit separierbaren eine Teilschaltermatrix enthaltenden Prüfschaltungs-Moduln, welche mit den Prüfstiften verbunden sind, und mit einem mit der Schaltermatrix verbundenen Steuerschaltungsteil.

Eine derartige Vorrichtung ist bekannt (JP-A-57 019 681, die der nachveröffentlichten US-A-4 417 204 entspricht). Bei der bekannten Vorrichtung sind die Prüfstifte in einer dicken Trägerplatte fest angeordnet. Mit Abstand über der Trägerplatte befindet sich ein Feld von Steckerleisten, in die jeweils mit einer Teil-Schaltermatrix bestückte elektronische Leiterplatten eingesteckt sind. Die bestückten Leiterplatten können als «Prüfschaltungs-Moduln» angesehen werden. Die Steckkontakte der Steckerleisten sind durch Drähte mit den Prüfstiften verbunden. Die Verdrahtung erfolgt auf beengtem Raum von Hand und ist dadurch aufwendig und teuer. Dies insbesondere dann, wenn die Zahl der Prüfstifte sehr gross ist. Jeder Prüfstift ist über den entsprechenden Verbindungsdraht mit einem elektronischen Schalter der betreffenden Teil-Schaltermatrix verbunden. Der Schalter kann den Prüfstift entweder mit einer Prüfstromquelle oder mit einem Prüfstromempfänger verbinden oder die Verbindung zu dem Prüfstift unterbrechen.

Ausgehend von der bekannten Prüfvorrichtung liegt der Erfindung die Aufgabe zugrunde, den Verdrahtungsaufwand zu vermeiden.

Die Aufgabe ist erfindungsgemäss dadurch gelöst, dass die Prüfstifte an den Prüfschaltungs-Moduln vorgesehen sind, und dass die Prüfschaltungs-Moduln so geformt sind, dass mit mehreren nebeneinander angeordneten Prüfschaltungs-Moduln ein lückenloses Abdecken des Lochrasterfeldes der zu prüfenden Leiterplatte mit Prüfstiften möglich ist.

Dadurch, dass die Prüfstifte an den separierbaren Prüfschaltungs-Moduln vorgesehen sind kann das Verdrahten von Hand entfallen. Zwar müssen auf die Schalter der Teil-Schaltermatrix an den einzelnen Prüfschaltungs-Moduln mit den an ihnen befindlichen Prüfkontakten verbunden werden; dazu können jedoch moderne Schaltmittel, die im Extremfall in einer direkten Integrierung bestehen können, verwendet werden. Ausserdem erfolgt die Herstellung der Prüfschaltungs-Moduln separat und nicht auf beengtem Raum.

Es ist zwar auch eine Prüfvorrichtung bekannt (US-A-4 164 704), bei der mehrere Prüfstifte in einem modulartigen Kunststoffblock zusammengefasst sind; dieser Kunststoffblock enthält jedoch keine Prüfschaltung. Er kann also auch nicht als «Prüfschaltungs-Modul» bezeichnet werden. Der Kunststoff-Block dient lediglich dazu, die Prüfstifte zusammenzuhalten und gemeinsam montieren bzw. demontieren zu können. Die Notwendigkeit der Herstellung einer Drahtverbindung zwischen den Prüfstiften und einer Prüfschaltung ist auch hier vorhanden.

Bekannt ist ferner eine Vorrichtung zum Prüfen von Chips (US-A-3 848 188), die nach Zeilen und Spalte geordnet auf einem gemeinsamen Substrat angeordnet sind. Das Substrat liegt auf einer Platte auf, welche einerseits angehoben und abgesenkt werden kann und andererseits stufenförmig seitlich vorwärtsbewegbar ist. Über dem Substrat befinden sich mehrere feststehende Prüfköpfe mit nach unten vorstehenden Prüfstiften, wobei jeweils ein Prüfkopf einem Chip in einer Zeile zugeordnet ist. Die Prüfköpfe sind mit einem Schalternetzwerk und dieses wiederum mit einem programmierbaren Tester-Netzwerk verbunden. Aus der Druckschrift kann jedoch nicht abgeleitet werden, dass das Schalternetzwerk und die Prüfstifte der Prüfköpfe bausteinartig zu einem Modul zusammengefasst sein sollen, schon gar nicht zu einem separierbaren Modul.

Eine sehr vorteilhafte zweckmässige Ausgestaltung der erfindungsgemässen Lösung kann darin bestehen, dass die Prüfschaltungs-Moduln an ihrer der zu prüfenden Leiterplatte abgewandten Seite abgestützt und so druckfest ausgebildet sind, dass sie den auf ihrer Prüfstifte auszuübenden Gesamtdruck zu übertragen vermögen. Die Prüfschaltungs-Moduln können dazu an ihrer der zu prüfenden Leiterplatte abgewandten Ende an einem Stützteil befestigt sein, welches über eine dehnungsfeste Verbindung mechanisch mit dem Auflageteil für die zu prüfende Leiterplatte verbunden ist. Durch diese Massnahme kann die dikke Trägerplatte für die Prüfstifte, die noch bei der eingangs beschriebenen bekannten Vorrichtung vorhanden sein muss, entfallen. Die beim Andruck der normalerweise federnd gelagerten Prüfstifte entstehende Drucklast wird von jedem der Moduln selbst aufgenommen. Wegen des blockförmigen Aufbaus eines Moduls und der begrenzten Anzahl der an ihm vorgesehenen Prüfstifte treten keine Verformungen an ihm auf.

Eine andere sehr vorteilhafte Ausgestaltung der erfindungsgemässen Lösung kann darin bestehen, dass eine sich parallel zu der zu prüfenden Leiterplatte erstreckende Rasterlochplatte mit Führungslöchern vorgesehen ist, auf die die Prüfschaltungs-Moduln aufsetzbar sind, derart, dass die Prüfstifte die Führungslöcher durchgreifen. Die Rasterlochplatte gewährleistet, dass die Prüfstifte auch an den Übergangsstellen zwischen den Moduln im Lochraster liegen.

Ein Ausführungsbeispiel der Erfindung wird nachfolgend anhand der Zeichnungen beschrieben.

Es zeigen:

Figur 1 eine schematisierte Seitenansicht einer Universal-Prüfvorrichtung;

Figur 2 einen Schnitt II–II durch Figur 1;

Figur 3 eine Draufsicht auf die Rasterlochplatte mit fünf Moduln (in anderer Anordnung als in Figur 2) mit einer daruntergelegenen Leiterplatte und den seitlichen Führungen;

Figur 4 einen Schnitt durch einen Modul parallel zu seiner Schmalseite sowie einen Schnitt durch einen Teil eines weiteren Moduls parallel zu seiner Längsseite sowie die Rasterlochplatte, die zu prüfende Leiterplatte und den Auflageteil;

Figur 5 einen Schnitt wie Figur 4, hier jedoch unter Verwendung eines Rasteranpassungsadapters für Leiterplatten, deren Löcher nicht im üblichen Raster angeordnet sind;

Figur 6 einen vergrösserten Prüfkopf aus Figur 5.

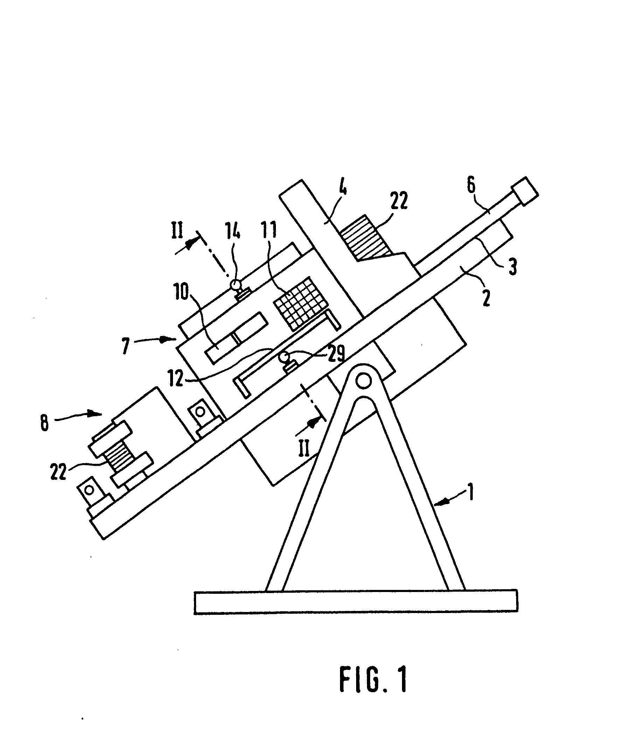

Die in Figur 1 dargestellte Universal-Prüfvorrichtung ist auf einem Gestell 1 angeordnet, das einen schrägen Tisch 2 trägt. Auf der Oberseite des Tisches befinden sich ein Magazin 4 für die zu prüfenden Leiterplatten 22.

Die Leiterplatten 22 werden mittels eines Schiebers taktweise aus einem Magazin 4 herausgeschoben. Zur Betätigung des Schiebers dient ein Pneumatic-Zylinder 6.

An das Magazin 4 schliesst sich ein Prüfteil 7 an. Der Prüfteil 7 weist ein Anzeigefenster 10 für die festgestellten Fehler auf. Ferner ist der Prüfteil 7 mit einem Tastenfeld 11 zum Eingeben der einzelnen Betriebsfunktionen versehen. Mittels eines Handgriffes 12 ist der Prüfteil um eine parallel zur schrägen Tischebene 3 in Figur 1 nicht sichtbare Schwenkachse nach oben schwenkbar.

Die geprüften Leiterplatten rutschen infolge der Schwerkraft auf der schrägen Tischebene 3 in einen Sortierteil 8. Der Steuerung des Sortierteiles 8 wird das Prüfergebnis des Prüfteiles 7 mitgeteilt, so dass der Sortierteil 8 die Leiterplatten in solche, die unerwünschte Leiterbahnverbindungen haben, in solche, die unerwünschte Leiterbahnunterbrechungen haben und in solche, die gut sind, sortiert. Das Stapel der guten Leiterplatten 22 ist in dem Sortierteil 8 erkennbar.

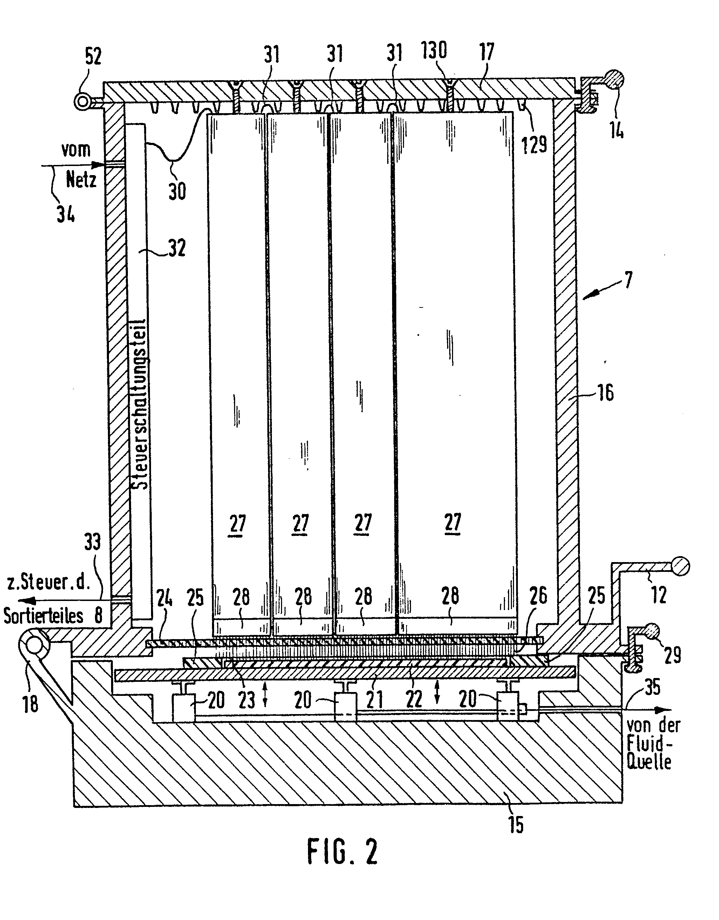

Gemäss Figur 2 besteht der Prüfteil 7 aus einem Unterteil 15 und einem Oberteil 16, die durch ein Scharniergelenk 18 miteinander verbunden sind. Der Oberteil 16 kann, wie bereits in Zusammenhang mit Figur 1 erwähnt, durch Anheben am Handgriff 12 hochgeschwenkt werden. Mittels eines Riegels 29 sind der Unterteil 15 und der Oberteil 16 miteinander verriegelbar.

Auf dem Oberteil 16 ist mit einer weiteren Scharnierverbindung 52 ein Stützteil 17 befestigt. Das Stützteil 17 ist um die Scharnierverbindung 52 gegenüber dem Oberteil 16 hochschwenkbar. Mittels eines Riegels 14 kann auch der Stützteil 17 mit dem Oberteil 16 verriegelt werden.

Innerhalb des Unterteiles 15 befindet sich eine Auflageplatte 21 für die zu prüfende Leiterplatte 22. Die Auflageplatte 21 ist mittels drei Hubzylindern 20 anhebbar bzw. absenkbar. Die drei Hubzylinder 20 werden über eine Leitung 35 von einer Fluidquelle mit Druckflüssigkeit oder Druckgas gespeist. In der abgesenkten Stellung fluchtet die Oberfläche der Auflageplatte 21 mit der Tischplattenoberseite 3 in Figur 1. Die Transportrichtung verläuft senkrecht zur Zeichnungsebene. Die auf der Auflageplatte 21 aufliegende Trägerplatte 23 wird beim Transport seitlich durch Führungen 25 begrenzt.

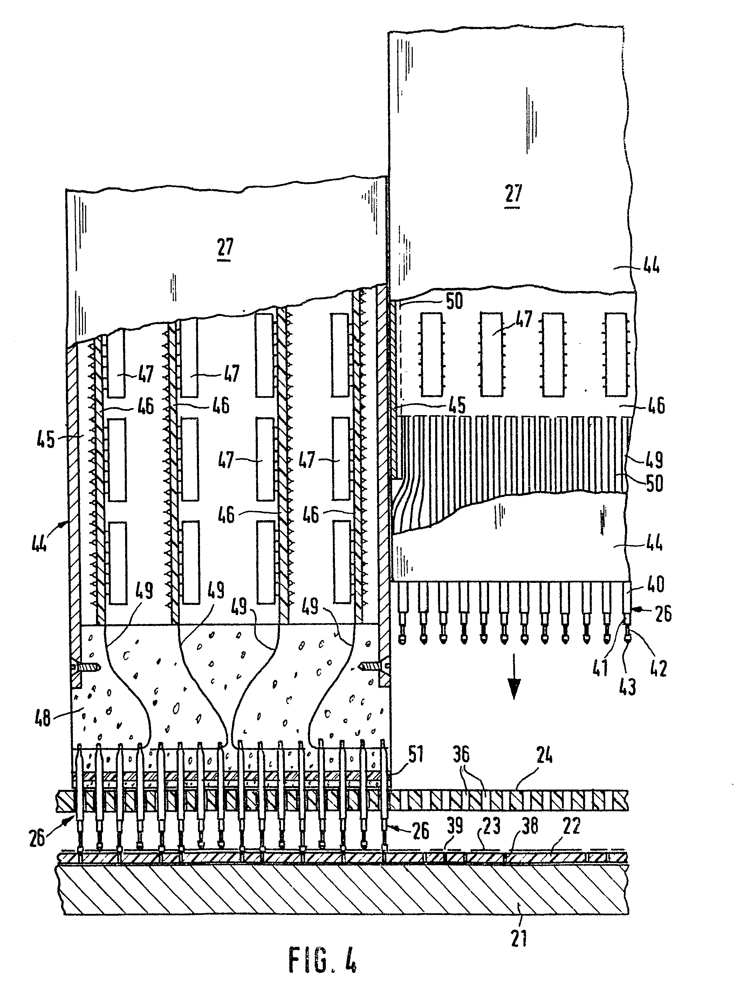

Oberhalb der zu prüfenden Leiterplatte 22, deren Löcher hier im üblichen Rastermass angeordnet sind, befindet sich im Oberteil 16 eine Rasterlochplatte 24 mit im ebenfalls in dem üblichen Raster angeordneten Führungslöchern 36 (siehe Figur 4). Auf der Oberseite der Rasterlochplatte 24 sind Moduln 27 aufgesetzt, die an ihren unteren Stirnseiten mit Prüfstiften 26 versehen sind, welche die Führungslöcher 36 in der Rasterlochplatte 24 durchgreifen. Über der zu prüfenden Leiterplatte 22 befindet sich eine Folie 23 mit Löchern 39 (siehe Figur 4), die nur denjenigen Prüfstiften 26 den Durchtritt auf die Leiterplatte 22 gestatten, welche auf Prüfpunkte der Leiterplatte treffen sollen. Die Folie 23, die aus Isoliermaterial besteht, ist in Transportrichtung vor der zu prüfenden Leiterplatte an der Unterseite der Rasterlochplatte 24 befestigt (nicht dargestellt) und verbleibt ständig in der Vorrichtung. Wenn ein neuer Leiterplattentyp geprüft werden soll, muss die Folie gewechselt werden. Die Folie hat die Aufgabe, zu verhindern, dass Prüfstifte, die nicht für ausgewählte Prüfpunkte der Leiterplatte bestimmt sind, zwischen zwei naheliegenden Leiterbahnen auftreffen und möglicherweise einen Kurzschluss herstellen. Ferner soll die Folie gewährleisten, dass die zu prüfende Leiterplatte durch Auftreffen nur der unbedingt notwendigen Zahl von Prüfstiften mechanisch geschont wird.

Auf die seitlichen Führungen 25 treffen ebenfalls Prüfstifte auf, da das durch die Prüfstifte sämtlicher Moduln definierte Teilrasterfeld wegen der festliegenden Abmessungen der Moduln in der Regel grösser als die Leiterplatte ist. Die seitlichen Führungen 25 müssen daher aus Isoliermaterial bestehen. Sie können beispielsweise an der Auflageplatte 21 verschiebbar befestigt sein.

Da die Prüfstifte federnd gelagerte Prüfspitzen 43 (siehe Figur 4) haben und die Leiterplatte 22 mittels der Hubzylinder 20 gegen die Prüfstifte 26 gedrückt wird, besteht die Tendenz, die Moduln 27 nach oben zu drücken. Um dies zu verhindern, ist das Stützteil 17 vorgesehen, das an seiner Unterseite Vorsprünge 129 aufweist, an denen sich die rückwärtigen Stirnseiten der Moduln 27 abstützen können. Da das Stützteil 17 mechanisch über die Scharnierverbindung 52 und die Verriegelung 14, das Oberteil 16 sowie die Scharnierverbindung 18 und die Verriegelung 29 mit dem Unterteil 15 verbunden ist, können sich die Moduln 27 demnach nicht unter dem Druck der Hubzylinder 20 und unter der Federkraft der Prüfstifte 26 nach oben bewegen. Die Moduln 27 sind ausserdem an dem Stützteil 17 befestigt, wie dies durch die Schrauben 130 angedeutet ist. Das bedeutet also, dass die Moduln 27 an dem Stützteil 17 hängen und die Rasterlochplatte 24 nicht durch ihr Gewicht auf Biegung beansprucht.

Die Zwischenräume zwischen den Vorsprüngen 29 erlauben es, elektrische Verbindungen 31 zwischen den Moduln 27 herzustellen. Mindestens einer der Moduln ist ferner über eine elektrische Verbindungsleitung 30 mit einem fest in dem Prüfteil vorgesehenen Steuerschaltungsteil 32 verbunden, das seinerseits über eine Leitung 34 mit dem Netz verbunden ist. Der Steuerschaltungsteil steuert die in jedem der Moduln 27 enthaltene Teil-Schaltermatrix. Die Teil-Schaltermatrix hat die Aufgabe, zeitlich nacheinander jeden der Prüfstifte in einen Prüfstromweg einzuschalten. Zu der in jedem Modul enthaltenen Teil-Schaltermatrix kann auch eine A/D-Wandlerschaltung gehören, die die analogen Prüfstromsignale in Digitalsignale umwandelt, welche dann von dem Steuerschaltungsteil 32 ausgewertet werden. Es ist aber auch möglich, dass die A/D-Umwandlung erst im Steuerschaltungsteil 32 erfolgt. Der Steuerschaltungsteil 32 sorgt also dafür, dass nacheinander die Prüfstifte jedes der Moduln 27 (wobei die Moduln 27 selbst zeitlich nacheinander an die Reihe kommen) mit dem Prüfstrom beaufschlagt werden. Die Schaltermatrix besteht praktisch aus einer Vielzahl von Halbleiter-Schaltern, die von dem Steuerschaltungsteil 32 nacheinander aufgerufen werden. In dem Steuerschaltungseil 32 wird dann das analoge oder digitalisierte Prüfstrom-Signal mit einem Sollwert verglichen. Eine Abweichung wird als Fehler registriert, der beispielsweise in einem Kurzschluss zwischen zwei Leiterbahnen oder in der Unterbrechung einer Leiterbahn bestehen kann. Der Steuerschaltungsteil 32 steuert dementsprechend über eine Leitung 33 den Sortierteil 8.

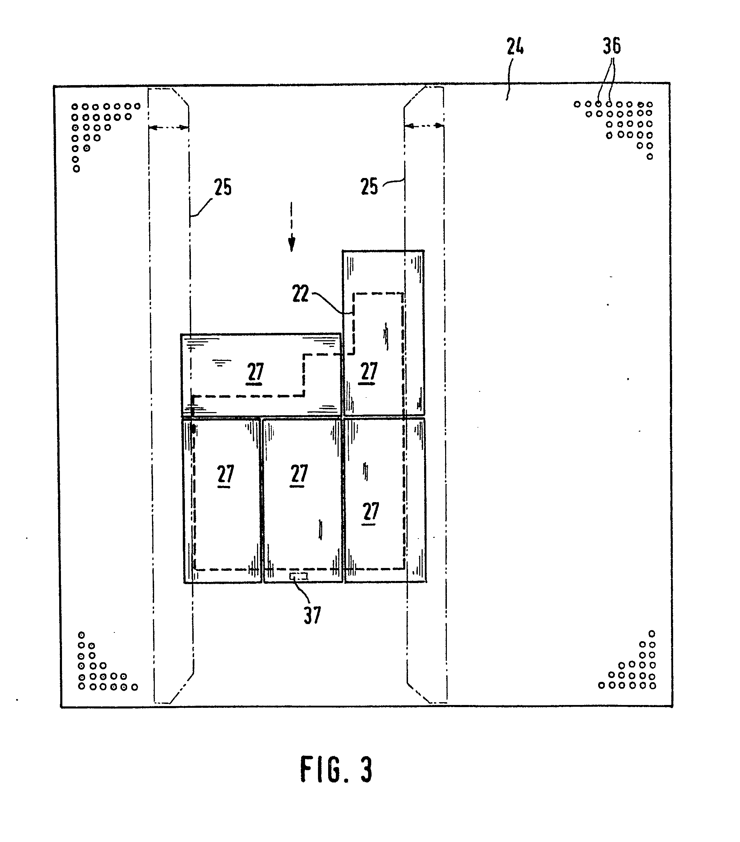

Figur 3 zeigt die Rasterlochplatte 24 von oben. Man erkennt, dass sie mit einer Vielzahl von Führungslöchern 36 versehen sind, die im Rastermass der zu prüfenden Leiterplatten angeordnet sind. Die Rasterlochplatte 24 deckt ein Rasterfeld ab, das so gross ist, dass jede mit der Prüfvorrichtung zu prüfende Leiterplatte mit ihren Abmessungen in dieses Rasterfeld fällt. In Figur 3 ist die zu prüfende Leiterplatte 22 sehr viel kleiner als das Gesamtrasterfeld der Rasterlochplatte 24. Zur Prüfung der Leiterplatte 22 genügen fünf Moduln 27, die baukastenförmig so angeordnet sind, dass sie bei geringstmöglicher Anzahl die zu prüfende Rasterfläche der Leiterplatte 22 gerade abdecken.

Man erkennt in Figur 3 ferner die seitlichen Führungen 25 für die zu prüfende Leiterplatte 22. Der Abstand der seitlichen Führungen 25 ist so gewählt, dass die Leiterplatte 22 eine reproduzierbare Position unter den Moduln 27 einnimmt und das Raster der Prüfstifte 26 der Moduln 27 in Übereinstimmung ist mit dem Raster der Leiterplatte 22. Um dies zu gewährleisten, ist ausserdem noch ein Anschlag 37 vorgesehen, der in Transportrichtung der zu prüfenden Leiterplatte 22 (siehe strichpunktierter Pfeil) vor der Leiterplatte angeordnet ist. Nachdem die Prüfung erfolgt ist, wird der Anschlag 37 abgesenkt und die geprüfte Leiterplatte 22 kann in Richtung auf die Sortiervorrichtung 8 passieren. Die Doppelpfeile an den seitlichen Führungen 25 sollen andeuten, dass Führungen in Anpassung an verschiedene Leiterplattentypen verstellbar sind. In Ergänzung zu Figur 2 soll an dieser Stelle noch darauf hingewiesen werden, dass die Höhe der Führungen 25 über der Auflageplatte 21 gerade gleich der Gesamthöhe der zu prüfenden Leiterplatte 22 und der darauf liegenden Folie 23 sein soll.

Figur 4 zeigt links einen Teilschnitt durch einen Modul 27 mit Blick auf die Schmalseite und rechts einen weiteren Modul 27 mit Blick auf die Breitseite, wobei von letzteren nur ein Teil zu sehen ist. Die Prüfstifte 26 des linken Moduls 27 durchgreifen die Führungsbohrungen 36 der Rasterlochplatte 24 und drücken mit ihren Prüfspitzen 43 entweder durch Löcher 39 in der Folie 23 auf Prüfpunkte der Leiterplatte 22 oder auf die Folie 23. Die Prüfpunkte der Leiterplatte sind in der Regel dort, wo Lötaugen sind, in deren Zentrum sich eine Bohrung 38 in der Leiterplatte 22 befindet.

Die Führungslöcher 36 in der Rasterlochplatte 24 haben einen etwas grösseren Durchmesser als die Prüfstifte 26, so dass letztere ohne grossen Kraftaufwand hindurchgesteckt und wieder herausgezogen werden können.

Jeder Modul 27 besteht aus einem quaderförmigen langgestreckten Gehäuse mit breiten Seitenwänden 44 und schmalen Seitenwänden 45. Die Seitenwände sind von Metallplatten gebildet. In den schmalen Seitenwänden 45 sind Nuten 50 vorgesehen, welche im vorliegenden Fall vier gedruckte Leiterplatten 46 eingeschoben sind. Auf die Leiterplatten sind IC-Chips 47 aufgesetzt und mit den Leiterbahnen verlötet. Die IC-Chips haben die Funktion eines steuerbaren elektrischen Schalters. In ihrer Gesamtheit bilden die Leiterplatten 46 mit den IC-Chips 47 und ggf. weiteren Bauelementen die den Prüfstiften 26 zugeordnete Teil-Schaltermatrix. Die eine Plattenoberseite jeder Leiterplatte 46 mit den darauf befindlichen Leiterbahnen 50 setzt sich in Richtung auf die Prüfstifte 26 fort. Der Endabschnitt jedes flexiblen Leiterbahnträgers 49 ist mit Löchern für die Enden der Prüfstifte versehen, die mit den Leiterbahnen 50 verlötet sind. Jeder Modul 27 hat beispielsweise 16 × 32 Prüfstifte, von denen bei dem linken Modul 27 nur die eine Schmalseite mit 16 Prüfstiften sichtbar ist. Senkrecht zur Zeichnungsebene erstreckt sich vor bzw. hinter jedem Prüfstift 25, fünfunddreissig weitere Prüfstifte. Jeder der Prüfstifte 26 ist mit einer der Leiterbahnen 50 verlötet.

Die Prüfstifte 26 bestehen aus einer Trägerhülse 40, in die eine Kolbenhülse 41 eingeschoben ist. In der Kolbenhülse 41 ist wiederum ein Kolbenstössel 42 mit Prüfspitze 43 verschiebbar gelagert. In der Kolbenhülse 41 ist (nicht sichtbar) eine Feder angeordnet, die den Kolbenstössel 42 mit Prüfspitze 43 in die Endposition zu drücken sucht.

Die Trägerhülsen 40 sitzen in im Rastermass der zu prüfenden Leiterplatte 22 angeordneten Bohrungen einer Trägerplatte 51. Die Trägerplatte 51 ist ihrerseits in ein Endstück 48 aus Giessharz eingebettet, welches mit seinem oberen Abschnitt in das aus den Wänden 44, 45 gebildete Gehäuse eingeschoben ist und dessen unterer Abschnitt die gleichen Aussenabmessungen wie das Gehäuse hat. Sinn dieses Endstückes ist es, zu gewährleisten, dass die beiden äusseren Prüfstifte 26 so nahe am Rand des Endstückes zu liegen kommen, dass bei im Baukastensystem zusammengefügten Moduln 27 im Grenzbereich kein Führungsloch 36 der Rasterlochplatte 24 frei bleibt. Mit anderen Worten, durch das Giessharzendstück 48 ist ein lückenloses Abdecken eines bestimmten Teil-Rasterfeldes durch mehrere nebeneinander angeordnete Moduln möglich. Ebenfalls dazu beitragen die flexiblen Leiterbahnträger 49, die am unteren Ende breiter sind, als im Übergangsbereich zur Oberfläche der Leiterplatten 46.

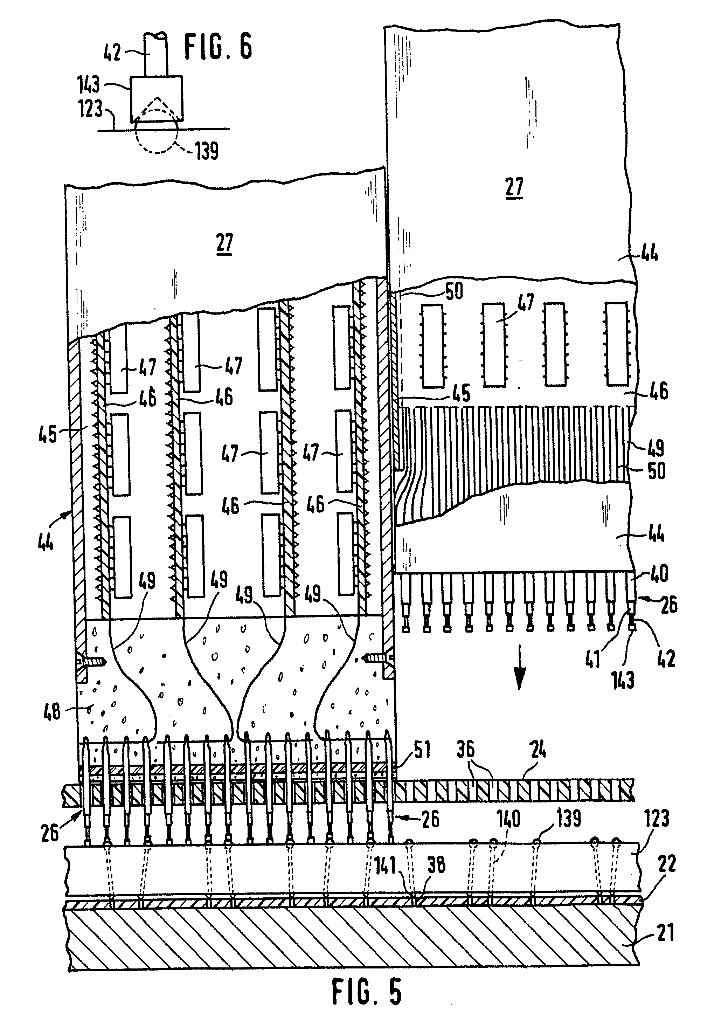

Figur 5 zeigt eine Ansicht wie Figur 4, jedoch für den Fall, dass die zu prüfende Leiterplatte 22 Löcher 38 aufweist, die nicht im üblichen Rastermass angeordnet sind.

Um die im Rastermass angeordneten Prüfstifte 26 der Moduln 27 in Kontakt mit den Löchern 38 der Leiterplatte 22 zu bringen, ist hier ein Rasteranpassungsadapter 123 dazwischengeschaltet. Dieser weist Verbindungsstifte 140 auf, die schräg verlaufen können. Diese haben oben einen balligen, vorzugsweise kugeligen Kopf 139 und unten eine Spitze 141, die mit den Löchern 38 der Leiterplatte 22 bzw. dem Leitermaterial, das die Löcher umgibt, in Kontakt ist. Die Prüfstifte 26 der Moduln 27 haben hier Prüfköpfe 143, die eine kalottenförmige oder hohlkegelförmige Ausnehmung aufweisen, in welche ein balliger Kopf 139 eines Prüfstiftes 140 eingreifen kann. Dies ist vergrössert in Figur 6 dargestellt.

**Patentansprüche**

1. Vorrichtung zum Prüfen von elektronischen Leiterplatten (22), mit einem Auflageteil (21) für die jeweils zu prüfende Leiterplatte (22), mit einer Vielzahl von im Lochraster der zu prüfenden Leiterplatte (22) angeordneten und mit dieser federnd kontaktierbaren Prüfstiften (26), mit separierbaren eine Teilschaltermatrix enthaltenden Prüfungsschaltungs-Moduln (27), welche mit den Prüfstiften elektrisch (26) verbunden sind, und mit einem mit der Schaltermatrix verbundenen Steuerschaltungsteil (32), dadurch gekennzeichnet, dass die Prüfstifte (26) an den Prüfschaltungs-Moduln (27) vorgesehen sind, und dass die Prüfschaltungs-Moduln (27) so geformt sind, dass mit mehreren nebeneinander angeordneten Prüfschaltungs-Moduln (27) ein lückenloses Abdecken des Lochrasterfeldes der zu prüfenden Leiterplatte (22) mit Prüfstiften (26) möglich ist.

2. Vorrichtung nach Anspruch 1, dadurch gekennzeichnet, dass die Prüfschaltungs-Moduln (27) an ihrer der zu prüfenden Leiterplatte (22) abgewandten Seite abgestützt und so druckfest ausgebildet sind, dass sie den auf ihre Prüfstifte (26) auszuübenden Gesamtdruck zu übertragen vermögen.

3. Vorrichtung nach Anspruch 1 oder 2, dadurch gekennzeichnet, dass eine sich parallel zu der zu prüfenden Leiterplatte (22) erstreckende Rasterlochplatte (24) mit Führugslöchern (36) vorgesehen ist, auf die die Prüfschaltungs-Moduln (27) aufsetzbar sind, derart, dass die Prüfstifte (26) die Führungslöcher (36) durchgreifen.

4. Vorrichtung nach einem der vorhergehenden Ansprüche, dadurch gekennzeichnet, dass jeder Prüfschaltungs-Modul (27) in einem Gehäuse (44, 45) untergebracht ist, das – im parallel zur zu prüfenden Leiterplatte (22) verlaufenden Schnitt gesehen – rechteckig ist.

5. Vorrichtung nach Anspruch 4, dadurch gekennzeichnet, dass das Gehäuse (44, 45) eine in Richtung senkrecht zur zu prüfenden Leiterplatte (22) langgestreckte Form hat.

6. Vorrichtung nach einem der vorherstehenden Ansprüche, dadurch gekennzeichnet, dass die Prüfschaltungs-Moduln (27) an ihrer der zu prüfenden Leiterplatte (22) abgewandten Seite an einem Stützteil (17) befestigt sind, welches über eine dehnungsfeste Verbindung (52, 14, 16, 18, 29, 15, 20) mechanisch mit dem Auflageteil (21) für die zu prüfende Leiterplatte (22) verbunden ist.

7. Vorrichtung nach einem der Ansprüche 4 bis 6, dadurch gekennzeichnet, dass die Prüfstifte (26) jedes Prüfschaltungs-Moduls (27) in einem Endstück (48) aus einem elektrisch nicht-leitenden Material, vorzugsweise Giessharz sitzen, der auf das der zu prüfenden Leiterplatte (22) zugewandte offene Ende des Modulgehäuses (44, 45) aufgesetzt ist und den gleichen Querschnitt wie das Modulgehäuse hat.

8. Vorrichtung nach einem der vorhergehenden Ansprüche, dadurch gekennzeichnet, dass der in jedem Prüfschaltungs-Modul (27) befindlichen Teil der Schaltermatrix die Form von mehreren senkrecht zur Rasterlochplatte (24) verlaufenden gedruckten und mit den entsprechenden Bauelementen (47) bestückten elektrischen Schaltmatrix-Leiterplatten (46) hat, und dass die die ebenfalls senkrecht zur Schaltermatrix verlaufenden Prüfstifte (26) mit den Schaltermatrix-Leiterplatten (46) durch flexible Leiterbahnenträger (49) verbunden sind.

9. Vorrichtung nach einem der vorhergehenden Ansprüche, dadurch gekennzeichnet, dass der Auflageteil (21) für die zu prüfende Leiterplatte (22) eine Auflageplatte ist, welche mittels eines Verstellvorrichtungsteils (20) in Richtung auf die Prüfschaltungs-Moduln (27) und wieder von diesen wegbewegbar ist.

10. Vorrichtung nach Anspruch 9, dadurch gekennzeichnet, dass der Verstellvorrichtungsteil von hydraulisch oder pneumatisch arbeitenden Hubzylindern (20) gebildet ist.

11. Vorrichtung nach einem der vorhergehenden Ansprüche, dadurch gekennzeichnet, dass seitliche Führungen (25) für die zu prüfenden und über das Auflageteil (21) zu transportierenden Leiterplatten (22) vorgesehen sind, und dass der Abstand der Führungen (25) quer zur Leiterplatten-Transportrichtung in Anpassung an die Abmessungen der Leiterplatten (22) veränderbar ist.

12. Vorrichtung nach einem der vorhergehenden Ansprüche, dadurch gekennzeichnet, dass die Prüfstifte (26) einen federnd gelagerten Prüfkopf (43) haben.

13. Vorrichtung nach Anspruch 12, dadurch gekennzeichnet, dass der Prüfkopf (43) der Prüfstifte für ein direktes Aufsetzen auf die zu prüfende Leiterplatte (22) eine Spitze hat.

14. Vorrichtung nach einem der Ansprüche 1 bis 12, dadurch gekennzeichnet, dass ein Rasteranpassungsadapter (123) zwischen den Prüfstiften (26) der Prüfschaltungs-Moduln (27) und der zu prüfenden Leiterplatte (22) angeordnet ist, dass die Prüfstifte (26) einen Prüfkopf (143) mit einer Ausnehmung haben, und dass der Rasteranpassungsadapter (123) Verbindungsstifte (140) aufweist, die einen balligen, vorzugsweise kugeligen Kopf (139) und eine Spitze (141) haben, wobei der ballige Kopf (139) in der Ausnehmung des Prüfkopfes (143) zu liegen kommt und die Spitze (141) zum Aufsetzen auf die zu prüfende Leiterplatte (22) bestimmt ist.

15. Vorrichtung zum Prüfen von elektronischen Leiterplatten (22), mit einem Auflageteil (21) für die jeweils zu prüfende Leiterplatte (22), mit einer Vielzahl von im Lochraster der zu prüfenden Leiterplatte (22) angeordneten und mit dieser federnd kontaktierbaren Prüfstiften (26), mit separierbaren eine Teil-Schaltermatrix enthaltenden Prüfschaltungs-Moduln (27), welche mit den Prüfstiften (26) elektrisch verbunden sind, und mit einem mit der Schaltermatrix verbundenen Steuerschaltungsteil (32), dadurch gekennzeichnet, dass die Prüfschaltungs-Moduln (27) so geformt sind, dass ihre der zu prüfenden Leiterplatte (22) zugewandte Stirnseite der Grösse eines Teilrasterfeldes entspricht, das durch die der Teil-Schaltermatrix zuzuordnende Teilzahl von Prüfstiften (26) bestimmt ist, dass die erwähnte Teilzahl von Prüfstiften (26) jeweils an der Stirnseite des betreffenden Prüfschaltungs-Moduls (27) vorgesehen ist, und dass die Prüfschaltungs-Moduln (27) ferner so geformt sind, dass mit mehreren nebeneinander angeordneten Prüfschaltungs-Moduln (27) ein lückenloses Abdecken des Lochrasterfeldes der zu prüfenden Leiterplatte (22) mit Prüfstiften (26) möglich ist.

16. Vorrichtung nach Anspruch 15, dadurch gekennzeichnet, dass die Prüfschaltungs-Moduln (27) an ihrer der zu prüfenden Leiterplatte (22) abgewandten Seite abgestützt und so druckfest ausgebildet sind, dass sie den auf ihre Prüfstifte (26) auszuübenden Gesamtdruck zu übertragen vermögen.

17. Vorrichtung nach Anspruch 15 oder 16, dadurch gekennzeichnet, dass eine sich parallel zu der zu prüfenden Leiterplatte (22) erstreckende Rasterlochplatte (24) mit Führungslöchern (36) vorgesehen ist, auf die die Prüfschaltungs-Moduln (27) aufsetzbar sind, derart, dass die Prüfstifte (26) die Führungslöcher (36) durchgreifen.

18. Vorrichtung zum Prüfen von elektronischen Leiterplatten (22) mit folgenden Merkmalen:

a) sie weist ein Auflageteil (21) für die jeweils zu prüfende Leiterplatte (22) auf,

b) die Prüfpunkte der Leiterplatte (22) werden von mit Prüfspitzen (141) versehenen Verbindungsstiften (140) eines Rasteranpassungsadapters (123) kontaktiert,

c) die Verbindungsstifte (140) stützen sich an Prüfstiften (26) ab und sind mit diesen elektrisch verbunden,

d) die Prüfstifte (26) sind im regulären Lochraster der zu prüfenden Leiterplatte (22) angeordnet und erstrecken sich durch Führungslöcher (36) einer Rasterlochplatte (24),

e) die Prüfstifte (26) sind mechanisch mit separierbaren Prüfschaltungs-Moduln (27) verbunden, derart, dass zwischen den Prüfstiften (26) und den Prüfschaltungs-Moduln (27) eine Druckübertragung gewährleistet ist,

f) die Prüfschaltungs-Moduln (27) sind an ihrer der zu prüfenden Leiterplatte (22) abgewandten Seite an einem Stützteil (17) abgestützt und so druckfest ausgebildet, dass sie den die Prüfstifte (26) auszuübenden Gesamtprüfdruck zu übertragen vermögen,

g) das Stützteil (17) ist über eine dehnungsfeste Verbindung (52, 14, 16, 18, 29, 15, 20) mechanisch mit dem Auflageteil (21) für die zu prüfende Leiterplatte (22) verbunden,

h) jeder Prüfschaltungs-Modul (27) enthält eine Teil-Schaltermatrix, welche elektrisch mit den dem Prüfschaltungs-Modul (27) zugeordneten Prüfstiften (26) verbunden ist,

i) die Teil-Schaltermatrix jedes Prüfschaltungs-Moduls (27) ist elektrisch mit einem Steuerschaltungsteil (32) verbunden,

j) die Prüfschaltungs-Moduln (27) sind so geformt, dass ein lückenloses Abdecken des Lochrasterfeldes der zu prüfenden Leiterplatte (22) mit den ihnen zugeordneten Prüfstiften (26) möglich ist.

## Claims

1. A device for testing electronic printed circuit boards (22) having a supporting part (21) for the printed circuit board (22) to be tested, a plurality of test pins (26) arranged in the hole grid of the printed circuit board (22) to be tested and able to make spring contact therewith, separable test switching modules (27) electrically connected with the test pins (26) and containing a partial switching matrix, and a control circuit part (32) connected with the switching matrix, characterised in that the test pins (26) are provided on the test switching modules (27) and that the test switching modules (27) are formed so that the hole matrix field of the printed circuit board (22) to be tested can be covered with test pins (26) without any gaps by means of a plurality of test switching modules (27) arranged side by side.

2. A device according to claim 1, characterised in that the test switching modules (27) are supported on their sides facing away from the printed circuit board (22) to be tested and are made so resistant to pressure that they are able to transmit the whole of the pressure to be exerted on their test pins (26).

3. A device according to claim 1 or claim 2, characterised in that a perforated grid plate (24) extending parallel to the printed circuit board (22) to be tested is provided with guide holes (36) on which the test switching modules (27) can be placed so that the test pins (26) engage through the guide holes (36).

4. A device according to any one of the preceding claims, characterised in that each test switching module (27) is contained in a housing (44, 45) that – when viewed in a section running parallel to the printed circuit board (22) to be tested – is rectangular.

5. A device according to claim 4, characterised in that the housing (44, 45) has a form elongated in the direction perpendicular to the printed circuit board (22) to be tested.

6. A device according to any one of the preceding claims, characterised in that the test switching modules (27) are fixed on their sides facing away from the printed circuit board (22) to be tested to a supporting part (17) which is mechanically connected via an elongation-resistant connection (52, 14, 16, 18, 29, 15, 20) to the supporting part (21) for the printed circuit board (22) to be tested.

7. A device according to any one of claims 4 to 6, characterised in that the test pins (26) of each test switching module (27) are seated in an end piece (48) of an electrically insulating material, preferably cast resin, that is placed on the open end of the module housing (44, 45) facing towards the printed circuit board (22) to be tested and has the same cross-section as the module housing.

8. A device according to any one of the preceding claims, characterised in that the part of the switching matrix located in each test switching module (27) has the form of a plurality of electrical switching matrix circuit boards (46), printed and fitted with the appropriate components (47), and extending at right angles to the perforated grid plate (24), and that the test pins (26) that likewise extend at right angles to the switching matrix are connected with the switching matrix printed circuit boards (46) by flexible printed conductor carriers (49).

9. A device according to any one of the preceding claims, characterised in that the supporting part (21) for the printed circuit board (22) to be tested is a supporting plate which can be moved towards and back away from the test switching modules (27) by means of a displacing device part (20).

10. A device according to claim 9, characterised in that the displacing device part is made up of hydraulically or pneumatically operating lifting cylinders (20).

11. A device according to any one of the preceding claims, characterised in that lateral guides (25) are provided for the printed circuit boards (22) to be tested and transported over the supporting part (21), and that the distance between the guides (25) transverse to the direction of transport of the printed circuit boards can be varied to suit the dimensions of the printed circuit boards (22).

12. A device according to any one of the preceding claims, characterised in that the test pins (26) have a spring mounted test head (43).

13. A device according to claim 12, characterised in that the test head (43) of the test pin has a prod for making direct contact with the printed circuit board (22) to be tested.

14. A device according to any one of claims 1 to 12, characterised in that a grid matching adapter (123) is arranged between the test pins (26) of the test switching modules (27) and the printed circuit board (22) to be tested, that the test pins (26) have a test head (143) with a recess, and that the grid matching adapter (123) has connecting pins (140) that have a crowned, preferably spherical head (139) and a tip (141), so that the crowned head (139) comes to lie in the recess of the test head (143) and the tip (141) is intended for making contact with the printed circuit board (22) to be tested.

15. A device for testing electronic printed circuit boards (22), having a supporting part (21) for the printed circuit board (22) to be tested, a plurality of test pins (26) arranged in the hole grid of the printed circuit board (22) to be tested and spring-contactable therewith, separable test switching modules (27) electrically connected with the test pins (26) and containing a partial switching matrix and a control circuit part (32) connected with the switching matrix, characterised in that the test switching modules (27) are formed so that their side facing the printed circuit board (22) to be tested corresponds to the size of a partial grid field that is determined by the number of the set of test pins (26) associated with the partial switching matrix, that the said number of test pins (26) is in each case provided on the face of the respective test switching module (27), and that the test switching module (27) is further so formed that the perforated grid field of the printed circuit board (22) to be tested can be covered without any gaps with test pins (26) by means of a plurality of test switching modules (27) arranged side by side.

16. A device according to claim 15, characterised in that the test switching modules (27) are supported on their sides facing away from the printed circuit board (22) to be tested and are made so resistant to pressure that they can transmit the whole of the pressure to be exerted on their test pins (26).

17. A device according to claim 15 or claim 16, characterised in that a perforated hole plate (24) extending parallel to the printed circuit board (22) to be tested is provided with the guide holes (36) on which the test switching modules (27) can be placed so that the test pins (26) engage through the guide holes (36).

18. A device for testing electronic printed circuit boards (22) having the following features:

a) it has a supporting plate (21) for the printed circuit board (22) to be tested,

b) the test points of the printed circuit board (22) are contacted by connecting pins (140) of a grid matching adapter (123) that are provided with test tips (141),

c) the connecting pins (140) are supported by the test pins (26) and are electrically connected therewith,

d) the test pins (26) are arranged in the regular hole grid of the printed circuit board (22) to be tested and extend through guide holes (36) of a perforated grid plate (24),

e) the test pins (26) are mechanically connected with separable test switching modules (27) so as to ensure transmission of pressure between the test pins (26) and the test switching modules (27),

f) the test switching modules (27) are supported on their sides facing away from the printed circuit board (22) to be tested on a supporting part (17) and are made so resistant to pressure that they can transmit the total pressure to be exerted on the test pins (26),

g) the supporting part (17) is mechanically connected with the supporting part (21) for the printed circuit board (22) to be tested through an elongation-resistant connection (52, 14, 16, 18, 29, 15, 20),

h) each test switching module (27) contains a partial switching matrix which is electrically connected with the test pins (26) associated with the test switching module (27),

i) the partial switching matrix of each test switching module (27) is electrically connected with a control circuit part (32),

j) the test switching modules (27) are formed so that the hole grid field of the printed circuit board (22) to be tested can be covered without any gaps by the test pins (26) associated with them.

**Revendications**

1. Appareil de contrôle de cartes imprimées (22) comportant une partie support (21) pour la carte (22) à contrôler, un grand nombre d'aiguilles de test (26) disposées suivant la grille de trous de la carte (22) à contrôler et pouvant être mises en contact élastiquement avec celle-ci, des modules de circuit de test séparables (27) qui contiennent une matrice de commutateurs partielle et sont reliés électriquement aux aiguilles de test (26), et une partie circuit de commande (32) reliée à la matrice de commutateurs, caractérisé en ce que les aiguilles de test (26) sont prévues sur les modules de circuit de test (27) et que les modules de circuit de test (27) sont faits de façon qu'une couverture complète avec des aiguilles de test (26) du champ de grille de trous de la carte (22) à contrôler soit possible avec plusieurs modules de circuit de test (27) placés côte à côte.

2. Appareil selon la revendication 1, caractérisé en ce que les modules de circuit de test (27) sont supportés sur leur côté opposé à la carte (22) à contrôler et sont suffisamment résistants à la pression pour pouvoir transmettre la pression totale exercée sur leurs aiguilles de test (26).

3. Appareil selon l'une des revendications 1 et 2, caractérisé en ce qu'il est prévu une plaque perforée (24) s'étendant parallèlement à la carte (22) à contrôler et pourvue de trous de guidage (36) sur laquelle les modules de circuit de test peuvent être posés de façon que les aiguilles de test (26) passent par les trous de guidage (36).

4. Appareil selon l'une des revendications précédentes, caractérisé en ce que chaque module de circuit de test (27) est logé dans un boîtier (44, 45) dont la section parallèle à la carte (22) à contrôler est rectangulaire.

5. Appareil selon la revendication 4, caractérisé en ce que le boîtier (44, 45) est allongé dans la direction perpendiculaire à la carte (22) à contrôler.

6. Appareil selon l'une des revendications précédentes, caractérisés en ce que les modules de circuit de test (27) sont fixés sur leur côté opposé à la carte (22) à contrôler à une partie d'appui (17) qui est liée mécaniquement par une liaison résistant à l'allongement (52, 14, 16, 18, 29, 25, 15, 20) à la partie support (21) supportant la carte (22) à contrôler.

7. Appareil selon l'une des revendications 4 à 6, caractérisé en ce que les aiguilles de test (26) de chaque module de circuit de test (27) sont montées dans une pièce d'extrémité (48) en matière non conductrice de l'électricité, de préférence en résine coulée, qui est placée sur l'extrémité ouverte du boîtier (44, 45) du module dirigée vers la carte (22) à contrôler et a la même section que ledit boîtier.

8. Appareil selon l'une des revendications précédentes, caractérisé en ce que la partie de la matrice de commutateurs se trouvant dans chaque module de circuit de test (27) est formée de plusieurs cartes imprimées (46) équipées des composants appropriés (47) placées perpendiculairement à la plaque perforée (24), et que les aiguilles de test (26), qui s'étendent également perpendiculairement à la matrice de commutation, sont reliées aux cartes (46) de cette dernière par des supports flexibles de conducteurs (49).

9. Appareil selon l'une des revendications précédentes, caractérisé en ce que la partie support (21) supportant la carte (22) à contrôler est une plaque support qui peut être approchée et éloignée des modules de circuit de test (27) au moyen de dispositifs de déplacement (20).

10. Appareil selon la revendication 9, caractérisé en ce que les dispositifs de déplacement sont formés de vérins hydrauliques ou pneumatiques (20).

11. Appareil selon l'une des revendications précédentes, caractérisé en ce qu'il est prévu des guides latéraux (25) pour les cartes (22) à contrôler et à transporter sur la partie support (21), et qu'on peut modifier la distance de ces guides (25) perpendiculairement à la direction de transport des cartes pour l'adapter aux dimensions des cartes (22).

12. Appareil selon l'une des revendications précédentes, caractérisé en ce que les aiguilles de test (26) ont une tête de test montée élastiquement (43).

13. Appareil selon la revendication 12, caractérisé en ce que la tête de test (43) des aiguilles de test a une pointe pour application directe sur la carte (22) à contrôler.

14. Appareil selon l'une des revendications 1 à 12, caractérisé en ce qu'un adaptateur de grille (123) est placé entre les aiguilles de test (26) des modules de circuit de test (27) et la carte (22) à contrôler, que les aiguilles de test (26) ont une tête de test (143) pourvue d'un évidement, et que l'adaptateur de grille (123) présente des aiguilles de liaison (140) qui ont une tête bombée de préférence sphérique (139) et une pointe (141), la tête bombée (139) venant se placer dans l'évidement de la tête de test (143) et la pointe (141) étant destinée à être appliquée sur la carte (22) à contrôler.

15. Appareil de contrôle de cartes imprimées (22) comportant une partie support (21) pour la carte (22) à contrôler, un grand nombre d'aiguilles de test (26) disposées suivant la grille de trous de la carte (22) à contrôler et pouvant être mises en contact élastiquement avec celle-ci, des modules de circuit de test séparables (27) qui contiennent une matrice de commutateurs partielle et sont reliés électriquement aux aiguilles de test (26), et une partie circuit de commande (32) reliée à la matrice de commutateurs, caractérisé en ce que les modules de circuit de test (27) sont faits de façon que leur face frontale dirigée vers la carte (22) à contrôler corresponde à la grandeur d'un champ de grille partiel déterminé par le nombre partiel d'aiguilles de test (26) à adjoindre à la matrice de commutateurs partielle, que ce nombre partiel d'aiguilles de test (26) est prévu sur la face frontale du module de circuit de test (27) concerné, et que les modules de circuit de test (27) sont en outre faits de façon qu'une couverture complète avec des aiguilles de test (26) du champ de grille de trous de la carte (22) à contrôler soit possible avec plusieurs modules de circuit de test (27) placés côte à côte.

16. Appareil selon la revendication 15, caractérisé en ce que les modules de circuit de test (27) sont supportés sur leur côté opposé à la carte (22) à contrôler et son suffisamment résistants à la pression pour pouvoir transmettre la pression totale exercée sur leurs aiguilles de test (26).

17. Appareil selon l'une des revendications 15 et 16, caractérisé en ce qu'il est prévu une plaque perforée (24) s'étendant parallèlement à la carte (22) à contrôler et pourvue de trous de guidage (36) sur laquelle les modules de circuit de test (27) peuvent être posés de façon que les aiguilles de test (26) passent par les trous de guidage (36).

18. Appareil de contrôle de cartes imprimées (22) ayant les caractéristiques suivantes:

a) il présente une partie support (21) pour la carte (22) à contrôler,

b) des aiguilles de liaison (140) d'un adaptateur de grille (123) pourvues de pointes de test (141) viennent en contact avec les points de test de la carte (22),

c) ces aiguilles de liaison (140) s'appuient sur des aiguilles de test (26) et sont liées électriquement à celles-ci,

d) les aiguilles de test (26) sont disposées sur la grille régulière de trous de la carte (22) à contrôler et passent par des trous de guidage (36) d'une plaque perforée (24),

e) les aiguilles de test (26) sont liées mécaniquement à des modules de circuit de test séparables (27) de façon telle qu'entre elles et ceux-ci soit assurée une transmission de pression,

f) les modules de circuit de test (27) sont supportés sur leur côté opposé à la carte (22) à contrôler par une partie d'appui (17) et sont suffisamment résistants à la pression pour pouvoir transmettre la pression de test totale exercée sur les aiguilles de test (26),

g) la partie d'appui (17) est liée mécaniquement par une liaison résistant à l'allongement (52, 14, 16, 18, 29, 15, 20) à la partie support (21) supportant la carte (22) à contrôler,

h) chaque module de circuit de test (27) contient une matrice de commutateurs partielle qui est reliée électriquement aux aiguilles de test (26) associées au module de circuit de test (27),

i) la matrice de commutateurs partielle de chaque module de circuit de test (27) est reliée électriquement à une partie circuit de commande (32), et

j) les modules de circuit de test (27) sont faits de façon qu'une couverture complète du champ de grille de trous de la carte (22) à contrôler soit possible avec les aiguilles de test (26) adjointes à ces modules.

FIG. 1

FIG. 2

FIG. 3

FIG. 4

FIG. 6

FIG. 5